# EUROPÄISCHE PATENTSCHRIFT

(11) **EP 3 678 815 B1**
(45) Veröffentlichungstag und Bekanntmachung des Hinweises auf die Patenterteilung: **23.03.2022**
(21) Anmeldenummer: 18765637.6
(22) Anmeldetag: 07.09.2018
(51) Int. Cl.: C23C 16/04

(54) **VORRICHTUNG ZUM BESCHICHTEN VON BEHÄLTERN**
DEVICE FOR COATING CONTAINERS
DISPOSITIF DE REVÊTEMENT DE RÉCIPIENTS

(30) Priorität: 07.09.2017 DE 102017120649
(43) Veröffentlichungstag der Anmeldung: 15.07.2020
(73) Patentinhaber: KHS Corpoplast GmbH, 22145 Hamburg (DE)
(72) Erfinder: KONRAD, Joachim, 40627 Düsseldorf (DE); KYTZIA, Sebastian, 23826 Todesfelde (DE); HERBORT, Michael, 20535 Hamburg (DE)
(74) Vertreter: Eisenführ Speiser
(86) Internationale Anmeldenummer: PCT/EP2018/074079
(87) Internationale Veröffentlichungsnummer: WO 2019/048585

(56) Entgegenhaltungen:
- EP-A1- 1 365 043
- DE-A1- 10 224 395
- JP-A- 2003 171 771
- US-A1- 2013 122 206

## Beschreibung

Die vorliegende Erfindung betrifft eine Vorrichtung zum Beschichten von Behältern mittels eines Beschichtungsverfahrens.

Aus dem Stand der Technik bekannte Behälterbeschichtungsmaschinen werden unter anderem zum Beschichten der Innenflächen von Behältern, wie PET-Flaschen, verwendet. Bei solchen Anlagen werden die Behälter in einen Förderbereich eingefördert, von dort mittels einer Übergabevorrichtung, beispielsweise einem Greifer, zu einer Vorrichtung gebracht und an diese übergeben, mittels der ein Prozessgas in den Behälter eingebracht wird und somit seine Innenfläche beschichtet wird. Nach der erfolgten Beschichtung bringt die Übergabevorrichtung den Behälter wieder zurück in den Förderbereich. Von dort wird er ausgefördert und gelangt in die weitere Produktionskette. Solche Anlagen müssen in vorgefertigten Einzelteilen - hierzu zählen beispielsweise eine Fördervorrichtung, die Übergabevorrichtung, eine Behandlungseinheit, eine Vakuumanlage und eine Anlage für das Prozessgas des Beschichtungsverfahrens; üblicherweise jeweils mit einer separaten Elektronik - zum vorgesehenen Standort gebracht werden und dort aufwendig installiert werden.

Dabei ist das Beschichtungsverfahren insbesondere eine unter Vakuum stattfindendes Abscheideverfahren, vorrangig ein CVD-Verfahren (Chemical Vapor Deposition). Relevanter Stand der Technik ist in den Patentdokumenten US2013/0122206 A1 und EP1365042 A1 offenbart.

Es ist die Aufgabe der vorliegenden Erfindung, eine Gesamtvorrichtung zur Verfügung zu stellen, die vor Ort einfacher installiert werden kann und deren Transport einfach erfolgen kann.

Diese Aufgabe wird erfindungsgemäß durch eine Vorrichtung mit den Merkmalen des Patentanspruchs 1 gelöst. Danach ist vorgesehen, dass alle für den Betrieb einer Vorrichtung zum Beschichten von Behältern mittels eines Beschichtungsverfahrens, insbesondere eines CVD-Verfahrens, in einem Tragrahmen angeordnet sind. Dieser Tragrahmen kann entweder einteilig oder mehrteilig sein. Dadurch, dass der Tragrahmen äußere Abmessungen hat, die kleiner sind als die Innenmaße eines ISO-Containers - der auch als Überseecontainer bezeichnet wird und gemäß der ISO-Norm 668 genormt ist; es gibt ihn mit einer Länge von 20 Fuß (6,096 m) oder 40 Fuß (12,192 m) Außenmaß; die 40 Fuß-Version ist auch in einer höheren Version (40' HC) standardmäßig bekannt: sie hat eine Außenhöhe von 2,896 m anstatt 2,591 m - und keiner der an ihm angebrachten Komponenten über dessen äußere Abmessungen herausstehen, kann die Vorrichtung beim Hersteller fast vollständig vorinstalliert werden und dann in einem solchen ISO-Container als Ganzes zum vorgesehenen Standort sicher und einfach transportiert werden. Die erfindungsgemäße Vorrichtung weist alle für den Betrieb nötigen Bereiche auf: Förderbereich, Übergabebereich, Behandlungsbereich, Elektronikbereich, Prozessgasaufbereitungsbereich und Vakuumpumpenbereich. Entweder die genannten Bereiche sind bereits vor dem Transport mit den nötigen Komponenten bestückt oder diese können aufgrund der voneinander getrennten Bereiche am geplanten Standort einfach in die Vorrichtung eingebaut werden. Zusätzlich ist in der erfindungsgemäßen Vorrichtung noch ein Wartungsbereich vorhanden, in dem keine Komponenten angeordnet sind. Von dort aus kann eine einfachere Wartung von ansonsten schwer zugänglichen Bereichen der Vorrichtung erfolgen, als bei konventionellen Vorrichtungen zum Beschichten von Behältern mittels eines Beschichtungsverfahrens.

Eine vorteilhafte Weiterbildung der Erfindung sieht vor, dass der Tragrahmen so ausgebildet ist, dass er die Komponenten in den einzelnen Bereichen an mindestens vier Seiten, bevorzugt an allen sechs Seiten, käfig- oder gitterartig umschließt. Dadurch ist ein guter Schutz der teilweise sehr sensiblen Komponenten der Vorrichtung durch den massiven und stabilen Tragrahmen gewährleistet.

Eine weitere vorteilhafte Weiterbildung der Erfindung sieht vor, dass die Abfolge der Bereiche in Längsrichtung wie folgt ist: Förderbereich, Übergabebereich, Behandlungsbereich, Wartungsbereich; und daran anschließend ein Prozesssegment angeordnet ist, das in beliebiger Anordnung zueinander den Elektronikbereich, den Prozessgasaufbereitungsbereich und den Vakuumpumpenbereich umfasst. Insbesondere durch die Anordnung des Wartungsbereichs rückseitig und direkt im Anschluss an den Behandlungsbereich mit der Behälterbehandlungseinheit kann diese bei Problemen - anders als dies regelmäßig aus dem Stand der Technik bekannten Vorrichtungen der Fall ist - gut erreicht werden und die Reparatur- oder Wartungsarbeiten problemlos durchgeführt werden.

Eine weitere vorteilhafte Weiterbildung der Erfindung sieht vor, dass sich an das Prozesssegment in Längsrichtung in folgender Abfolge weitere Bereiche anschließen: ein weiterer Wartungsbereich, ein weiterer Behandlungsbereich, ein weiterer Übergabebereich und ein weiterer Förderbereich; wobei die Komponenten im Prozesssegment sowohl die schon vorhandenen als auch die hinzugetretenen Bereiche versorgen. Dadurch erhält man eine quasi spiegelbildliche Ausgestaltung der Vorrichtung um das Prozesssegment herum mit zwei Behälterbehandlungseinheiten und jeweiliger Beschickungsvorrichtungen, wobei die Komponenten des Prozesssegments nur einfach vorhanden sind und von den verdoppelten Komponenten gemeinsam genutzt werden. Damit kann die doppelte Menge von Behältern pro Zeiteinheit beschichtet werden, wobei die Kosten hierfür deutlich niedriger liegen, als wenn zwei Vorrichtungen angeschafft würden; außerdem wird Platz eingespart, da die Komponenten des Prozesssegments nicht doppelt vorhanden sein müssen.

Eine weitere vorteilhafte Weiterbildung der Erfindung sieht vor, dass sich zwischen Wartungsbereich und Prozesssegment in folgender Abfolge weitere Bereiche anschließen: ein weiterer Behandlungsbereich, ein weiterer Übergabebereich und ein weiterer Förderbereich. Auch hierdurch wird ein doppelter Durchsatz an Behältern erreicht. Der Unterschied zu der Ausgestaltung gemäß dem vorangehenden Absatz liegt nur darin, dass eine spiegelbildliche Ausgestaltung der mit den Behältern in direkten Kontakt kommenden Komponenten um einen gemeinsamen Wartungsbereich vorliegt und sich das Prozesssegment daneben anschließt. Die Vorteile entsprechen den im vorangehenden Absatz ausgeführten Vorteilen.

Eine weitere vorteilhafte Weiterbildung der Erfindung sieht vor, dass die Übergabevorrichtung im Übergabebereich und/oder weiteren Übergabebereichen jeweils mindestens einen Greiferschlitten aufweist und die Behandlungseinheit im Behandlungsbereich und/oder weiteren Behandlungsbereichen jeweils mit einer vorgebbaren Anzahl von Plätzen, bevorzugt vier Plätze, aufweist, die als einzelne Vakuumkammern oder gemeinsame Vakuumkammer ausgebildet sind. Mittels eines Greiferschlittens kann eine gute Bewegung der Behälter von der Fördervorrichtung zur Behälterbehandlungseinheit erfolgen und die Übergabe in beide Richtungen sehr exakt durchgeführt werden. Durch die Mehrzahl an Plätzen der Behälterbehandlungseinheit kann eine Erhöhung des Durchsatzes gegenüber der Verwendung nur eines einzelnen Platzes erreicht werden; der Greiferschlitten kann auch mit gleich vielen Greifern ausgestattet werden, wie Plätze an der Behälterbehandlungseinheit vorhanden sind.

Eine weitere vorteilhafte Weiterbildung der Erfindung sieht vor, dass ein erster Greifersschlitten zwischen einem ersten Förderbereich und einem ersten Behandlungsbereich angeordnet ist und ein zweiter Greifersschlitten zwischen einem zweiten Förderbereich und einem zweiten Behandlungsbereich angeordnet ist; wobei der erste Förderbereich entlang einer Stirnfläche des Tragrahmens ist und der zweite Förderbereich zwischen den Behandlungsbereichen und dem Prozesssegment angeordnet ist; wobei ein weiterer Wartungsbereich für den zweiten Behandlungsbereich an derselben Stirnfläche des Trägerrahmens wie der erste Förderbereich angeordnet ist und der Wartungsbereich für den ersten Behandlungsbereich, wie der zweite Förderbereich, zwischen den Behandlungsbereichen und dem Prozesssegment angeordnet ist. Dies stellt eine weitere Möglichkeit einer kompakten Vorrichtung bei gleichzeitig effizienter Nutzung der Komponenten des Prozesssegments, wie dies oben schon für die beiden anderen Ausgestaltungen mit jeweils zwei Behandlungsbereichen der Fall war. Hinsichtlich der Vorteile wird auf die dortigen Ausführungen verwiesen.

Eine weitere vorteilhafte Weiterbildung der Erfindung sieht vor, dass mindestens eine der Fördervorrichtungen eine automatisierte Verstellvorrichtung für die Breite ihrer Gasse aufweist. Dadurch ist es möglich, Behälter verschiedener Größe - insbesondere von Flaschen unterschiedlichen Durchmessers - mit derselben Vorrichtung sicher befördern und übergeben zu können, ohne einer erhöhten Gefahr eines Umfallens, wie dies bei einer sehr viel breiteren Gasse als der Durchmesser des gerade zu behandelnden Behälters der Fall wäre.

Eine weitere vorteilhafte Weiterbildung der Erfindung sieht vor, dass der Förderbereich und/oder der weitere Förderbereich jeweils zwei voneinander entkoppelte Teilfördervorrichtungen, eine Einfördervorrichtung und eine Ausfördervorrichtung, aufweisen. Dadurch können schon Behälter eingefördert werden und zur Übergabe vorbereitet werden, während noch Behälter auf der anderen Teilfördervorrichtung aufgesetzt werden und diese sich deshalb noch nicht bewegt. Dasselbe gilt auch für umgekehrt: Die Teilfördervorrichtung zum Einfördern steht schon, da die dort befindlichen Behälter von der Übergabevorrichtung aufgenommen werden, während die andere Teilfördervorrichtung Behälter ausfördert.

Eine weitere vorteilhafte Weiterbildung der Erfindung sieht vor, dass der Prozessgasaufbereitungsbereich einen unbeheizten Bereich aufweist, in dem ein Trägergasmassenflussregler und ein Absolutdruckaufnehmer angeordnet sind. Damit können diese Geräte innerhalb ihrer Spezifikation betrieben werden. Dies wäre nicht der Fall, wenn diese Geräte, wie dies regelmäßig im Stand der Technik der Fall ist, zusammen mit den Massenflussreglern der Monomere in einem beheizten Bereich der Prozessgasanlage; die höhere Temperatur bei den zuletzt genannten Massenflussreglern ist nötig, um höhere Volumenströme des Prozessgases zu erreichen.

Eine weitere vorteilhafte Weiterbildung der Erfindung sieht vor, dass der Vakuumpumpenbereich zwei Teilbereiche aufweist, idealerweise zwei räumlich voneinander getrennte Teilbereiche: einen Vorvakuum-Teilbereich für die Erzeugung eines Vorvakuums und einen Prozessvakuum-Teilbereich zur Erzeugung eines Prozessvakuums. Dadurch können die für die Erzeugung des Vorvakuums benötigten Komponenten einfach zusammen ausgetauscht werden; dasselbe gilt für die zusammengehörigen Komponenten für die Erzeugung des Prozessvakuums.

Alle in den Unteransprüchen angegebenen Merkmale der vorteilhaften Weiterbildungen sind sowohl für sich jeweils einzeln als auch in beliebigen Kombinationen zur Erfindung gehörig.

Weitere Einzelheiten und Vorteile der Erfindung werden anhand von in den Zeichnungen dargestellten Ausführungsbeispielen näher erläutert.

Es zeigen:
- Figur 1: eine Schrägansicht eines erfindungsgemäßen Tragrahmens einer erfindungsgemäßen Vorrichtung,
- Figur 2: eine schematische Darstellung eines ersten Ausführungsbeispiels einer erfindungsgemäßen Vorrichtung in der Draufsicht,
- Figur 3: eine schematische Darstellung eines zweiten Ausführungsbeispiels einer erfindungsgemäßen Vorrichtung in der Draufsicht,
- Figur 4: eine schematische Darstellung eines dritten Ausführungsbeispiels einer erfindungsgemäßen Vorrichtung in der Draufsicht,
- Figur 5: eine schematische Darstellung eines vierten Ausführungsbeispiels einer erfindungsgemäßen Vorrichtung in der Draufsicht,
- Figur 6: eine schematische Darstellung eines fünften Ausführungsbeispiels einer erfindungsgemäßen Vorrichtung in der Draufsicht und
- Figur 7: eine schematische Darstellung eines sechsten Ausführungsbeispiels einer erfindungsgemäßen Vorrichtung in der Draufsicht.

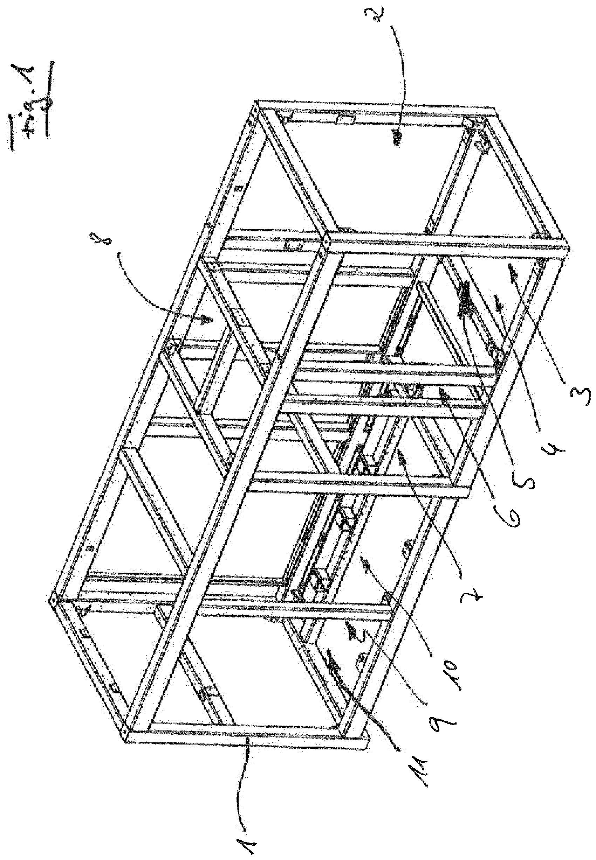

Figur 1 zeigt einen erfindungsgemäßen Tragrahmen 1 einer erfindungsgemäßen Vorrichtung zum Beschichten von Behältern mittels eines Beschichtungsverfahrens. Der Tragrahmen 1 weist eine käfigartige Struktur auf. In ihn werden die für die Beschichtung benötigten Komponenten eingefügt, so dass sie nicht über seine äußeren Streben herausstehen. Dadurch sind diese Komponenten (nicht dargestellt) auch bei einem Transport der Vorrichtung durch den Tragrahmen 1 gut geschützt. Die äußeren Streben des Tragrahmens spannen im Wesentlichen einen Quader auf. Die Außenabmessungen dieses Quaders sind so, dass er in einen ISO-Container passt. Die Innenmaße eines solchen ISO-Containers (es werden diejenigen eines 40 Fuß HC-Modells (40' HC) angegeben) sind: Breite 2,352 m; Höhe 2,698 m; Länge 12,032. Ein 20 Fuß-Modell (20') unterscheidet sich davon nur in seiner Länge, die 5,898 m beträgt. Ein 40 Fuß-Modell (40') unterscheidet sich von dem erstgenannten nur in seiner Höhe, die 2,385 m beträgt.

Die Außenmaße des Tragrahmens 1 sind so gewählt, dass sie geringfügig in Breite und Höhe kleiner sind als die oben genannten Innenmaße des ISO-Containers. Beispielsweise weist das in Figur 1 dargestellte Ausführungsbeispiel eine Breite von 2,150 m, eine Höhe von 2,560 m und eine Länge von 6,292 m auf. Da die in dem Tragrahmen 1 angebrachten Komponenten nicht über diesen herausstehen, kann die mit allen benötigten Komponenten bestückte Vorrichtung zum Beschichten von Behältern mittels eines Beschichtungsverfahrens als ganzes in einen ISO-Container verladen werden und mit diesem einfach und sicher an den Aufstellungsort transportiert werden. Dort wird die Vorrichtung dann aus dem ISO-Container herausgenommen und muss nur noch mit geringfügigem Aufwand in eine Produktionskette integriert werden, indem die Schnittstellen dazu mit einer Fördervorrichtung (oder mehreren Fördervorrichtungen) innerhalb des Tragrahmens 1 verbunden werden.

In dem Tragrahmen sind verschiedene Bereiche ausgebildet, die entweder durch entsprechende Streben voneinander abgegrenzt werden oder von denen mehrere zusammengefasst von entsprechenden Streben begrenzt werden. Ausgehend von seiner Stirnseite 2 ist die Abfolge dieser Bereiche wie folgt:
Ein Förderbereich 3; daran schließen sich ein Übergabebereich 4 und im Anschluss daran ein Behandlungsbereich 5 an. Diese drei Bereiche erstrecken sich über die gesamte Breite des Tragrahmens 1. Sie sind zwischen der ersten und zweiten vertikalen Strebe des Tragrahmens 1 ausgebildet.

Zwischen der zweiten und dritten vertikalen Strebe erstreckt sich ebenfalls über die gesamte Breite des Tragrahmens 1 ein Wartungsbereich 6.

Zwischen dritter und vierter vertikaler Strebe sind nebeneinander zwei Bereiche angeordnet: in der Darstellung von der Stirnseite 2 aus betrachtet links ein Elektronikbereich 7 und rechts ein Prozessgasaufbereitungsbereich 8.

Zwischen vierter und sechster (letzter) vertikaler Strebe ist ein Vakuumpumpenbereich 9 ausgebildet, in dem sich die für die Erzeugung des für den Beschichtungsprozess notwendigen Vakuums benötigten Komponenten befinden. Der Vakuumpumpenbereich 9 ist dabei durch die fünfte vertikale Strebe in zwei Teilbereiche unterteilt. Von der Stirnseite 2 des Tragrahmens 1 aus gesehen vor dieser Strebe liegt ein im Rahmen dieser Anmeldung als Vorvakuum-Teilbereich 10 bezeichneter Teilbereich, der zur Erzeugung des Vorvakuums dient; hinter der fünften vertikalen Strebe liegt ein im Rahmen dieser Anmeldung als Prozessvakuum-Teilbereich 11 bezeichneter Teilbereich, der zur Erzeugung des Prozessvakuums dient.

Das Strebenraster, das heißt die Position und Anzahl der vertikalen Streben, kann dabei natürlich bedarfsweise variiert werden.

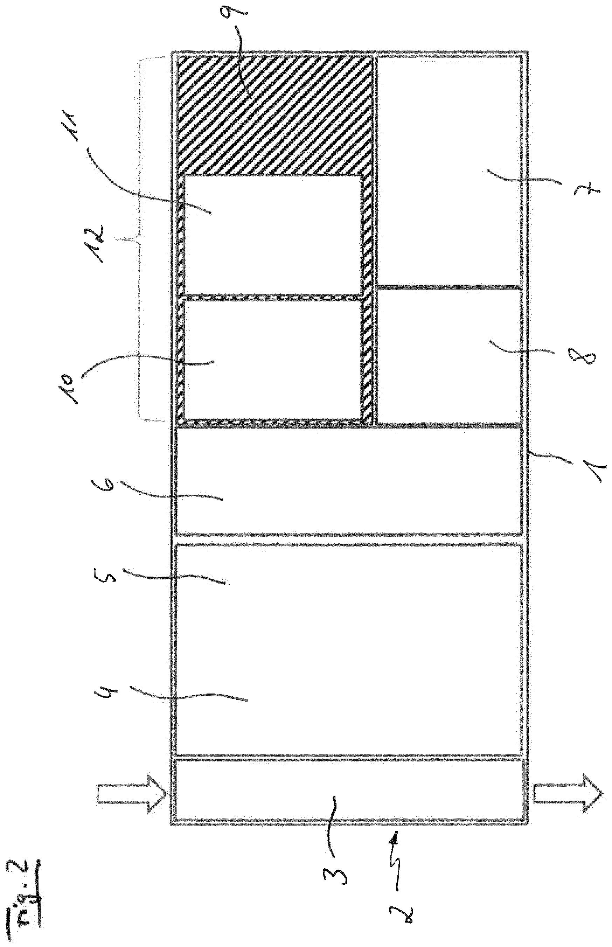

In den Figuren 2 bis 7 sind sechs erfindungsgemäße Ausführungsbeispiele dargestellt, die unterschiedliche Anordnungen der Bereiche haben. Diese Figuren zeigen jeweils stark schematisch vereinfachte Draufsichten.

In Figur 2 befindet sich an der Stirnseite 2 des Tragrahmens 1 der Förderbereich 3, in dem eine einzige durchgängige Fördervorrichtung in der Form eines Förderbandes vorhanden ist. Durch die Pfeile werden die Einförderrichtung (oben in Figur 2) und die Ausförderrichtung (unten in Figur 2). An den jeweiligen Schnittstellen (siehe Pfeile) zur erfindungsgemäßen Vorrichtung sind Interfaces zur Ankopplung der Vorrichtung in eine Produktionslinie vorhanden.

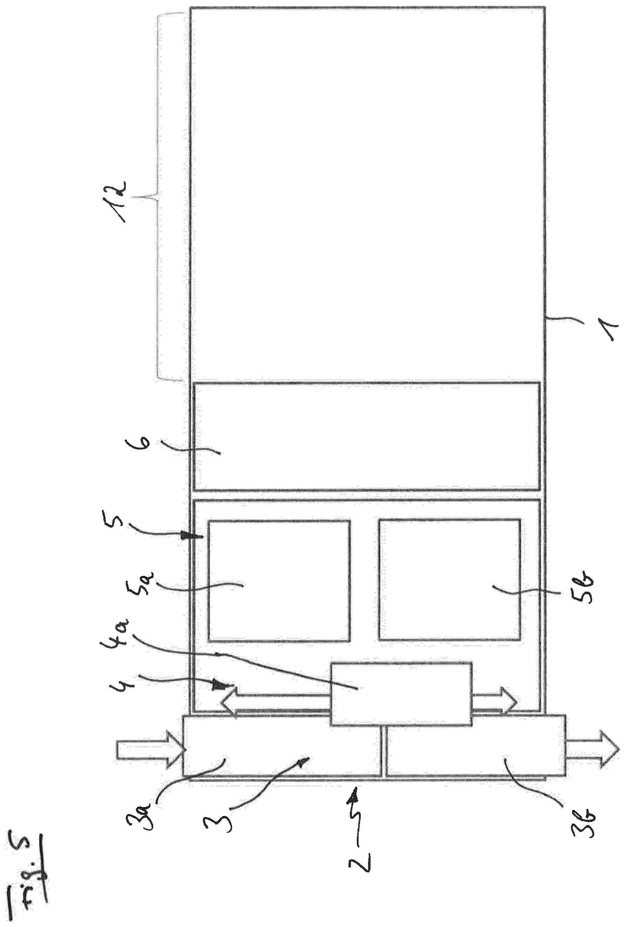

In dem Übergabebereich 4 ist eine Übergabevorrichtung, wie beispielsweise ein Greiferschlitten 4a, 4b, 4c (siehe Figuren 5-7), angeordnet, die die auf dem Förderband eingeförderten Behälter greift und in eine im Behandlungsbereich 5 vorhandene Behandlungseinheit 5a, 5b (siehe Figuren 5-7) bewegt. Dort werden die Behälter mittels eines Beschichtungsverfahrens beschichtet. Nach der Durchführung des Beschichtungsverfahrens werden die Behälter von der Übergabevorrichtung wieder zurück zum Förderband bewegt und dort auf diesem abgestellt, so dass eine Ausförderung in Richtung de s unteren Pfeils erfolgt und die beschichteten Behälter weiter in der Produktionskette laufen.

Der hinter dem Behandlungsbereich 5 ausgebildete Wartungsbereich 6 ist von außen gut zugänglich (beispielsweise über eine Tür). In ihm sind keine Komponenten angeordnet und man kommt gut an die Behandlungseinheit heran, um sie warten oder reparieren zu können.

Um das Beschichtungsverfahren durchzuführen, werden entsprechende Prozessgas benötigt, die teilweise aufbereitet werden müssen. Diese werden dann über Rohrleitungen (nicht dargestellt) vom Prozessgasaufbereitungsbereich 8 zu der Behandlungseinheit gebracht. Vorteilhafterweise ist in dem Prozessgasaufbereitungsbereich 8 ein insbesondere unbeheizter Bereich vorhanden, in dem alle hierfür erforderlichen verfahrenstechnischen Prozesskomponenten, wie bspw. ein Trägergasmassenflussregler und ein Absolutdruckaufnehmer angeordnet sind. Damit können diese Geräte innerhalb ihrer Spezifikation betrieben werden. Dies wäre deutlich schwieriger bzw. nicht der Fall, wenn diese Geräte zusammen mit den Massenflussreglern der Monomere in einem anderen, beheizten Teilbereich des Prozessgasaufbereitungsbereich 8 angeordnet wären; die höhere Temperatur bei den zuletzt genannten Massenflussreglern ist Bereich der Prozessgasanlage nötig, um höhere Volumenströme des Prozessgases zu erreichen.

Da sich der Prozessgasaufbereitungsbereich 8 nicht über die gesamte Breite des Trägerrahmens 1 erstreckt, ist im anderen Teil der Vakuumpumpenbereich 9 angeordnet. In diesem wird das ebenfalls für das Beschichtungsverfahren benötigte Vakuum erzeugt. Hierfür ist eine Anzahl von Vakuumpumpen nötig. Diese sind in separaten Teilbereichen angeordnet, je nach ihrer Funktion: es gibt Vakuumpumpen, die für die Erzeugung eines Vorvakuums nötig sind - diese sind in dem Vorvakuum-Teilbereich 10 zusammengefasst - und es gibt Vakuumpumpen, die für die Erzeugung eines Prozessvakuums nötig sind - diese sind in dem Prozessvakuum-Teilbereich 11 zusammengefasst. Die Vakuumpumpen sind über nicht gezeigte Rohre untereinander und mit der Behandlungseinheit verbunden. Aufgrund der modularen Gruppierung kann eine einfachere Austauschbarkeit der zusammengehörigen Komponenten erreicht werden.

Um alle innerhalb des Tragrahmens 1 angeordneten Komponenten mit Strom zu versorgen, ihre Funktionen zu steuern, usw. sind in dem Elektronikbereich alle dementsprechenden elektrischen und elektronischen Bauteile in einem Schaltschrank zusammengefasst. Hierzu werden alle derartigen Bauteile gut zugänglich in unmittelbarer Nähe zueinander angeordnet; dies ist wartungs- und reparaturfreundlich.

Die zuletzt genannten Bereiche Elektronikbereich 7, Prozessgasaufbereitungsbereich 8 und Vakuumpumpenbereich 9 werden auch zusammengefasst als Prozesssegment bezeichnet.

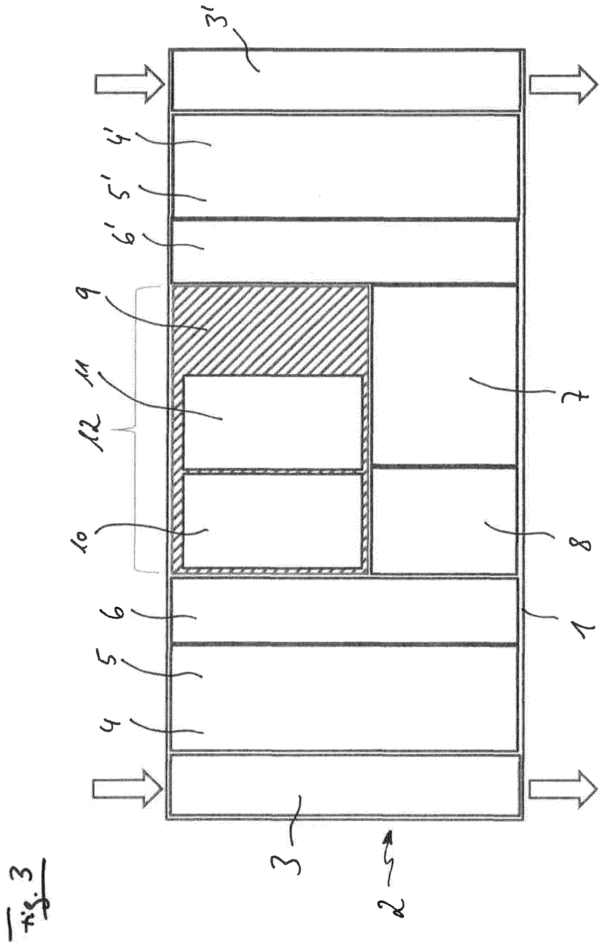

Das in Figur 3 bargestellte Ausführungsbeispiel unterscheidet sich von demjenigen der Figur 2 nur dadurch, dass von der Stirnseite 2 aus gesehen hinter dem Prozesssegment 12 quasi spiegelbildlich zu den Bereichen erster Förderbereich 3, erster Übergabebereich 4, erster Behandlungsbereich 5 und erster Wartungsbereich 6 diese noch einmal in umgekehrter Reihenfolge vorhanden sind. Ausgehend von dem Prozesssegment sind dies ein zweiter Wartungsbereich 6', ein zweiter Behandlungsbereich 5', ein zweiter Übergabebereich 4' und ein zweiter Förderbereich 3'. Deren Funktionen sind gleich wir die entsprechenden Bereiche, die zu Figur 2 beschrieben wurden. Der Vorteil hierbei ist, dass ein doppelt so hoher Durchsatz wie mit einer Vorrichtung nach Figur 2 erzielt werden kann und aber die Komponenten des Prozesssegments nicht auch verdoppelt werden müssen. Somit werden Platz und Kosten eingespart.

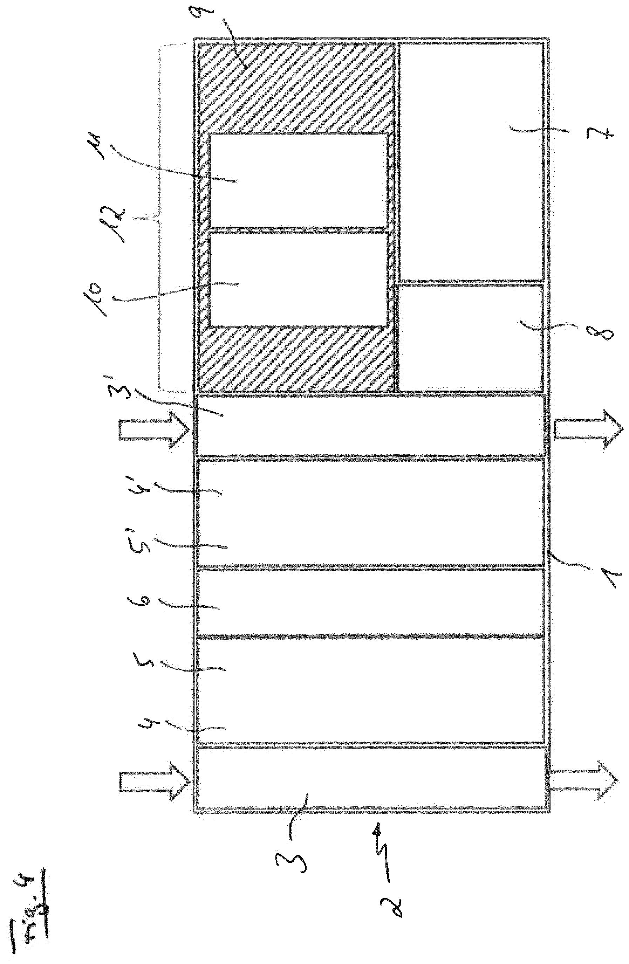

Der Unterschied des Ausführungsbeispiels der Figur 4 zu demjenigen der Figur 3 besteht nur darin, dass die zweiten Bereiche, die in Figur 2 rechts des Prozesssegments 12 angeordnet waren nunmehr zwischen dem Prozesssegment 12 und dem (ersten) Wartungsbereich 6 angeordnet sind und dieser (erste) Wartungsbereich 6 mit dem zweiten Wartungsbereich 6' der Figur 3 zusammenfällt. Auch hier lässt sich derselbe Durchsatz wie mit der Vorrichtung gemäß Figur 3 erzielen.

Der Unterschied zwischen dem vierten Ausführungsbeispiel der Figur 5 und dem ersten Ausführungsbeispiel der Figur 2 liegt darin, dass im Förderbereich 3 nicht ein durchgängiges Förderband vorhanden ist, sondern zwei getrennt voneinander bedienbare Förderbänder: eine Einfördervorrichtung 3a und eine Ausfördervorrichtung 3b. Damit kann das Einfördern unabhängig vom Ausfördern erfolgen. Diese hat beispielsweise den Vorteil bei der Verwendung eines (einzigen) Greiferschlittens 4a, dass während dieser die Behälter von der angehaltenen Einfördervorrichtung 3a abhebt, Behälter auf der Ausfördervorrichtung 3b stehende Behälter ausgefördert werden können. Das gilt natürlich auch für den umgekehrten Fall. Der einzelne Greiferschlitten 4a bestückt zwei Behandlungseinheiten insbesondere mit jeweils mehreren Stationen - eine erste Behandlungseinheit 5a und eine zweite Behandlungseinheit 5b. Dadurch kann ein höherer Durchsatz erreicht werden, als wenn nur eine Behandlungseinheit vorhanden wäre.

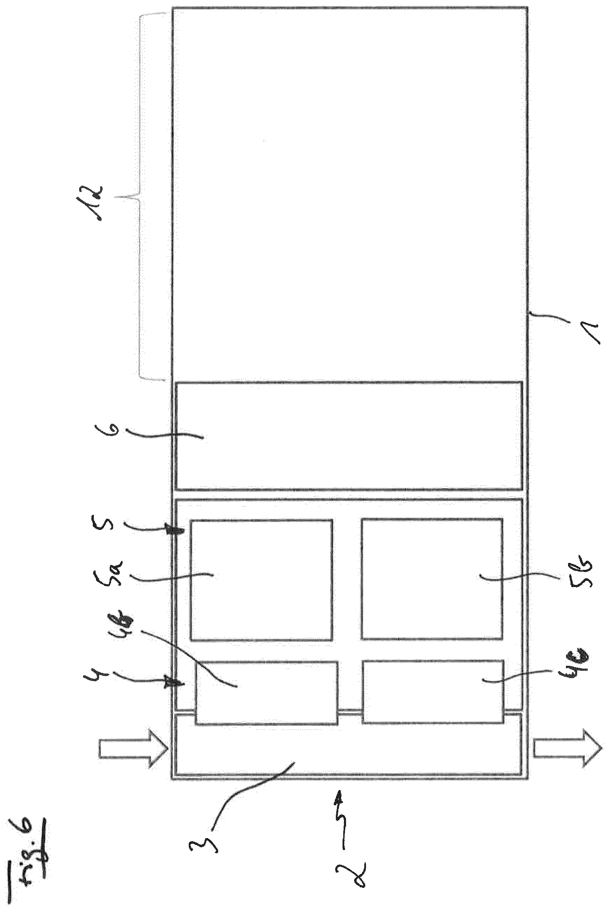

Der Unterschied zwischen dem fünften Ausführungsbeispiel der Figur 6 und dem vierten Ausführungsbeispiel der Figur 5 liegt darin, dass im Förderbereich 3 nur ein einziges durchgängiges Förderband vorhanden ist (wie in den Ausführungsbeispielen der Figuren 2-4) und zwei Greiferschlitten - ein erster Greiferschlitten 4b, der der ersten Behälterbehandlungseinheit 5a zugeordnet ist, und ein zweiter Greiferschlitten 4c, der der zweiten Behälterbehandlungseinheit 5b zugeordnet ist - vorhanden sind. Dadurch kann zwar eine schnellere Beschickung der beiden Behälterbehandlungseinheiten 5a, 5b erfolgen, da nicht ein einziger Greiferschlitten ständig hin und her fahren muss (auch um die Behälter von der Einfördervorrichtung 3a zur Ausfördervorrichtung 3b zu überheben, aber es ist der doppelte Aufwand hinsichtlich der Greiferschlitten 4b, 4c notwendig.

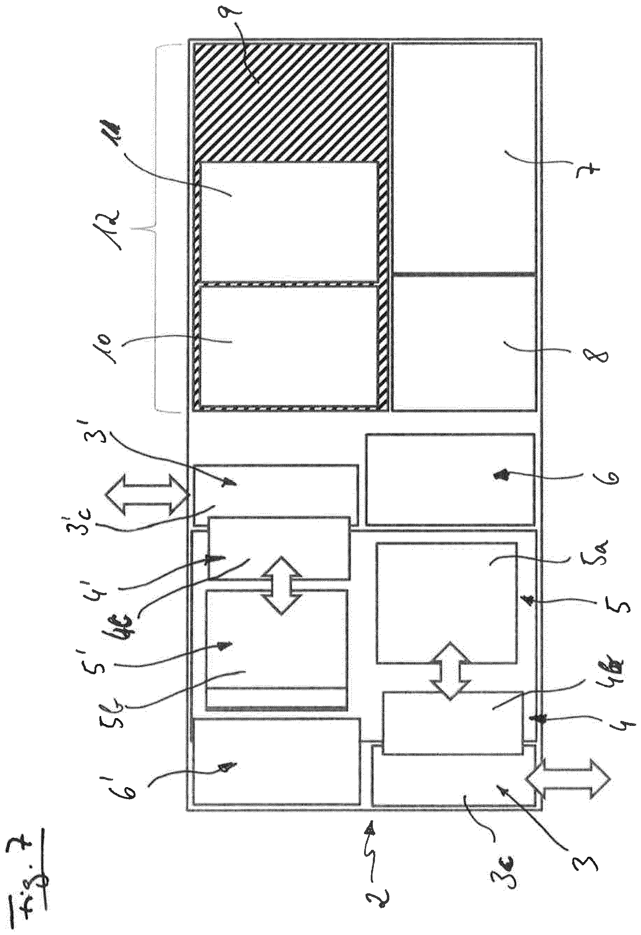

Das sechste Ausführungsbeispiel der Figur 7 ist gegenüber dem dritten Ausführungsbeispiel der Figur 4 wie folgt verändert: Anstatt sich jeweils über die gesamte Breite des Trägerrahmens 1 zu erstrecken, erstreckt sich das Ensemble aus erstem Förderbereich 3, erstem Übergabebereich 4, erstem Behandlungsbereich 5 und erstem Wartungsbereich 6 nur über dessen halbe Breite. In der anderen Hälfte ist in umgekehrter Reihenfolge ein gleiches Ensemble angeordnet (ausgehend von der Stirnfläche 2): weiterer Wartungsbereich 6', weiterer Behandlungsbereich 5', weiterer Übergabebereich 4' und weiterer Förderbereich 3'. Der Unterschied zu allen anderen Ausführungsbeispielen liegt darin, dass jede der beiden in den Förderebereichen 3, 3' angeordneten Fördervorrichtungen - die erste Fördervorrichtung 3c und die zweite Fördervorrichtung 3'c - in beide Richtungen betreibbar sein müssen, um sowohl ein Einfördern der unbeschichteten Behälter als auch ein Ausfördern der beschichteten Behälter durchführen zu können. Dies stellt eine weitere Möglichkeit einer kompakten Vorrichtung bei gleichzeitig effizienter Nutzung der Komponenten des Prozesssegments 12, wie dies oben schon für die beiden anderen Ausgestaltungen mit jeweils zwei Behandlungsbereichen 5a, 5b der Fall war. Hinsichtlich der Vorteile wird auf die dortigen Ausführungen verwiesen. Vergleichbar dem fünften Ausführungsbeispiel der Figur 6 sind zwei Greiferschlitten - ein erster Greiferschlitten 4b, der der ersten Behälterbehandlungseinheit 5a zugeordnet ist, und ein zweiter Greiferschlitten 4c, der der zweiten Behälterbehandlungseinheit 5b zugeordnet ist - vorhanden. Zwar ist die Anordnung der einzelnen Bereiche gegenüber der Figur 6 nicht in die gleiche Richtung, sondern entgegengesetzt, aber es ergeben sich dieselben Vorteile, wie oben zu Figur 6 ausgeführt.

Weiterhin können natürlich auch alterntive Ein- und Ausförderer vorgesehen werden, wie beispielsweise parallele Bänder, wobei dann die zugehörigen Greifer und ein Greiferschlitten entsprechend angepasst werden muss.

### Bezugszeichenliste

- 1: Tragrahmen
- 2: Stirnfläche
- 3: (erster) Förderbereich
- 3a: Einfördervorrichtung
- 3b: Ausfördervorrichtung
- 3c: erste Fördervorrichtung
- 3': weiterer Förderbereich
- 3'c: zweite Fördervorrichtung
- 4: (erster) Übergabebereich
- 4a: einzelner Greiferschlitten
- 4b: erster Greiferschlitten
- 4c: zweiter Greiferschlitten
- 4': weiterer Übergabebereich
- 5: (erster) Behandlungsbereich
- 5a: erste Behälterbehandlungseinheit
- 5b: zweite Behälterbehandlungseinheit
- 5': weiterer Behandlungsbereich
- 6: (erster) Wartungsbereich
- 6': weiterer Wartungsbereich
- 7: Elektronikbereich
- 8: Prozessgasaufbereitungsbereich
- 9: Vakuumpumpenbereich
- 10: Vorvakuum-Teilbereich
- 11: Prozessvakuum-Teilbereich
- 12: Prozesssegment

## Patentansprüche

1. Vorrichtung zum Beschichten von Behältern mittels eines Beschichtungsverfahrens mit einem Tragrahmen (1), dessen äußere Abmessungen kleiner sind als die Innenmaße eines ISO-Containers, in den die Vorrichtung zum Transport einbringbar ist,
wobei innerhalb des Tragrahmens (1) folgende Bereich vorhanden sind:
- ein Förderbereich (3), in dem mindestens eine Fördervorrichtung für die Behälter angeordnet ist,
- ein Behandlungsbereich (5) vorhanden ist, in dem mindestens eine Behälterbehandlungseinheit zur Beschichtung der Behälter angeordnet ist,
- ein Übergabebereich (4), in dem eine Übergabevorrichtung angeordnet ist, die die Behälter zwischen Fördervorrichtung und Behälterbehandlungseinheit bewegt,
- ein von außen gut zugänglicher Wartungsbereich (6), der rückseitig zu der mindestens einen Behälterbehandlungseinheit angeordnet ist,
- ein Elektronikbereich (7), in dem ein Schaltschrank für die Elektronik der Komponenten der Vorrichtung angeordnet ist,
- ein Prozessgasaufbereitungsbereich (8), in dem die Komponenten für das Handling des Prozessgases für das Beschichtungsverfahren angeordnet sind,
- ein Vakuumpumpenbereich (9), in dem Vakuumpumpen zur Erzeugung des für das Beschichtungsverfahren benötigte Vakuum angeordnet sind.

2. Vorrichtung nach Patentanspruch 1, wobei der Tragrahmen (1) so ausgebildet ist, dass er die Komponenten in den einzelnen Bereichen an mindestens vier Seiten, bevorzugt an allen sechs Seiten, käfig- oder gitterartig umschließt.

3. Vorrichtung nach einem der vorstehenden Patentansprüche, wobei die Abfolge der Bereiche in Längsrichtung wie folgt ist: Förderbereich (3), Übergabebereich (4), Behandlungsbereich (5), Wartungsbereich (6); und daran anschließend ein Prozesssegment (12) angeordnet ist, das in beliebiger Anordnung zueinander den Elektronikbereich (7), den Prozessgasaufbereitungsbereich (8) und den Vakuumpumpenbereich (9) umfasst.

4. Vorrichtung nach Patentanspruch 3, wobei sich an das Prozesssegment (12) in Längsrichtung in folgender Abfolge weitere Bereiche anschließen: ein weiterer Wartungsbereich (6'), ein weiterer Behandlungsbereich (5'), ein weiterer Übergabebereich (4') und ein weiterer Förderbereich (3'); wobei die Komponenten im Prozesssegment (12) sowohl die schon vorhandenen als auch die hinzugetretenen Bereiche versorgen.

5. Vorrichtung nach Patentanspruch 3, wobei sich zwischen Wartungsbereich (6) und Prozesssegment (12) in folgender Abfolge weitere Bereiche anschließen: ein weiterer Behandlungsbereich (5'), ein weiterer Übergabebereich (4') und ein weiterer Förderbereich (3').

6. Vorrichtung nach einem der vorstehenden Patentansprüche, wobei die in den genannten Bereichen angeordneten Komponenten nicht über den durch die äußeren Abmessungen des Tragrahmens (1) vorgegebenen Bereich herausstehen.

7. Vorrichtung nach einem der vorstehenden Patentansprüche, wobei der von außen gut zugänglicher Wartungsbereich (6), der rückseitig zu der Behandlungseinheit angeordnet ist und in dem weiterhin keine Komponenten angeordnet sind.

8. Vorrichtung nach einem der vorstehenden Patentansprüche, wobei die Übergabevorrichtung im Übergabebereich (4) und/oder weiteren Übergabebereich (4') jeweils mindestens einen Greiferschlitten (4a, 4b, 4c) aufweist und die Behandlungseinheit im Behandlungsbereich (5) und/oder weiteren Behandlungsbereich (5') jeweils eine Vakuumkammer mit einer vorgebbaren Anzahl von Plätzen, bevorzugt vier Plätze, aufweist.

9. Vorrichtung nach Patentanspruch 8, wobei ein erster Greiferschlitten (4b) zwischen einem ersten Förderbereich (3) und einem ersten Behandlungsbereich (5) angeordnet ist und ein zweiter Greiferschlitten (4c) zwischen einem weiteren Förderbereich (3') und einem weiteren Behandlungsbereich (5') angeordnet ist; wobei der erste Förderbereich (3) entlang einer Stirnfläche (2) des Tragrahmens (1) und der weitere Förderbereich (3') zwischen den Behandlungsbereichen (5, 5') und dem Prozesssegment (12) angeordnet ist; wobei ein weiterer Wartungsbereich (6') für den weiteren Behandlungsbereich (5') an derselben Stirnfläche (2) des Trägerrahmens (1) wie der erste Förderbereich (3) angeordnet ist und der Wartungsbereich (6) für den ersten Behandlungsbereich (5), wie der zweite Förderbereich (3'), zwischen den Behandlungsbereichen (5, 5') und dem Prozesssegment (12) angeordnet ist.

10. Vorrichtung nach einem der vorstehenden Patentansprüche, wobei mindestens eine der Fördervorrichtungen (3, 3') eine Verstellvorrichtung für die Breite ihrer Gasse aufweist.

11. Vorrichtung nach einem der vorstehenden Patentansprüche, wobei der Förderbereich (3) und/oder der weitere Förderbereich (3') jeweils zwei voneinander entkoppelte Teilfördervorrichtungen, eine Einfördervorrichtung (3b) und eine Ausfördervorrichtung (3c), aufweisen.

12. Vorrichtung nach einem der vorstehenden Patentansprüche, wobei der Prozessgasaufbereitungsbereich (8) einen unbeheizten Bereich aufweist, in dem ein Trägergasmassenflussregler und ein Absolutdruckaufnehmer angeordnet sind.

13. Vorrichtung nach einem der vorstehenden Patentansprüche, wobei der Vakuumpumpenbereich (9) zwei räumlich voneinander getrennte Teilbereiche aufweist: einen Vorvakuum-Teilbereich (10) für die Erzeugung eines Vorvakuums und einen Prozessvakuum-Teilbereich (11) zur Erzeugung eines Prozessvakuums.

## Claims

1. Device for coating containers by means of a coating process with a support frame (1), the external dimensions of which are smaller than the internal dimensions of an ISO container, into which the device for transport can be inserted,
wherein the following areas are available within the support frame (1):
- a conveying area (3) in which at least one conveying device for the containers is arranged,
- a treatment area (5) is available in which at least one container treatment unit for coating the containers is arranged,
- a transfer area (4) in which a transfer device is arranged that moves the containers between the conveying device and the container treatment unit,
- a maintenance area (6) which is easily accessible from the outside, which is arranged on the rear side of at least one container treatment unit,
- an electronics area (7) in which a control cabinet for the electronics of the components of the device is arranged,
- a process gas treatment area (8) in which the components for handling the process gas for the coating process are arranged,
- a vacuum pump area (9) in which vacuum pumps are arranged to generate the vacuum required for the coating process.

2. Device according to Claim 1, wherein the support frame (1) is designed in such a way that it encloses the components within the individual areas on at least four sides, preferably on all six sides, in a cage-like or lattice-like manner.

3. Device according to any one of the preceding claims, wherein the sequence of areas in the longitudinal direction is as follows: a conveying area (3), a transfer area (4), a treatment area (5), a maintenance area (6); and subsequently, a process segment (12) is arranged, which, in any arrangement with relation to one another, comprises the electronics area (7), the process gas treatment area (8) and the vacuum pump area (9) .

4. Device according to Claim 3, wherein the process segment (12) in the longitudinal direction is followed by further areas in the following sequence: another maintenance area (6'), another treatment area (5'), another transfer area (4') and another conveying area (3'); wherein the components in the process segment (12) supply both the existing as well as the added areas.

5. Device according to Claim 3, wherein, between maintenance area (6) and process segment (12) in the following sequence, further areas follow: a further treatment area (5'), another transfer area (4') and another conveying area (3').

6. Device according to any one of the preceding claims, wherein the components arranged in the said areas do not project beyond the area specified by the external dimensions of the support frame (1).

7. Device according to any one of the preceding claims, wherein the maintenance area (6), which is easily accessible from the outside, is arranged on the rear side to the treatment unit and in which further no components are arranged.

8. Device according to any one of the preceding claims, wherein the transfer device in the transfer area (4) and/or further transfer area (4') each comprises at least one gripper carriage (4a, 4b, 4c), and the treatment unit in the treatment area (5) and/or further treatment area (5') each comprises a vacuum chamber with a specifiable number of spaces, preferably four spaces.

9. Device according to Claim 8, wherein a first gripper carriage (4b) is arranged between a first conveying area (3) and a first treatment area (5), and a second gripper carriage (4c) is arranged between a further conveying area (3') and a further treatment area (5'); wherein the first conveying area (3) is arranged along an end face (2) of the support frame (1) and the further conveying area (3') between the treatment areas (5, 5') and the process segment (12); wherein a further maintenance area (6') for the further treatment area (5') is arranged on the same end face (2) of the support frame (1) as the first conveying area (3) and the maintenance area (6) for the first treatment area (5), as the second conveying area (3'), is arranged between the treatment areas (5, 5') and the process segment (12) .

10. Device according to any one of the preceding claims, wherein at least one of the conveyor devices (3, 3') comprises an adjustment device for the width of its pathway.

11. Device according to any one of the preceding claims, wherein the conveying area (3) and/or the further conveying area (3') each comprise two decoupled sub-conveying devices, a feed conveying device (3b) and a outfeed conveying device (3c).

12. Device according to any one of the preceding claims, wherein the process gas treatment area (8) comprises an unheated area in which a carrier gas mass flow controller and an absolute pressure transducer are arranged.

13. Device according to any one of the preceding claims, wherein the vacuum pump area (9) comprises two spatially separated subareas: a pre-vacuum subarea (10) for the generation of a pre-vacuum and a process vacuum subarea (11) for the generation of a process vacuum.

## Revendications

1. Dispositif de revêtement de récipients au moyen d'un procédé de revêtement, muni d'un bâti de support (1) dont les dimensions extérieures sont inférieures aux dimensions intérieures d'un conteneur ISO dans lequel le dispositif peut être placé en vue de son transport,
l'intérieur du bâti de support (1) présentant les zones suivantes :
- une zone de transport (3) dans laquelle est disposé au moins un dispositif de transport des récipients ;
- une zone de traitement (5), dans laquelle est disposée au moins une unité de traitement de récipients pour le revêtement des récipients ;
- une zone de transfert (4) dans laquelle est disposé un dispositif de transfert qui déplace les récipients entre le dispositif de transport et l'unité de traitement de récipients ;
- une zone de maintenance (6) bien accessible de l'extérieur disposée à l'arrière de l'unité ou des unité(s) de traitement de récipients ;
- une zone électronique (7) dans laquelle est disposée une armoire de distribution pour l'équipement électronique du dispositif ;
- une zone de traitement du gaz de procédé (8) dans laquelle sont disposés les éléments de manipulation du gaz de procédé utilisé pour le procédé de revêtement ;
- une zone pour pompes à vide (9) dans laquelle sont disposées des pompes à vide pour l'évacuation requise par le procédé de revêtement.

2. Dispositif selon la revendication 1, le bâti de support (1) étant conçu de manière à entourer les composants des différentes zones à l'instar d'une cage ou d'une grille sur quatre côtés au moins et de préférence sur tous les six côtés.

3. Dispositif selon l'une des revendications précédente, la succession longitudinale des zones étant la suivante : zone de transport (3), zone de transfert (4), zone de traitement (5), zone de maintenance (6) et, à la suite de ces zones, un segment de procédé (12) englobant selon un ordre quelconque la zone électronique (7), la zone de traitement du gaz de procédé (8) et la zone pour pompes à vide (9).

4. Dispositif selon la revendication 3, le segment de procédé (12) étant suivi, en sens longitudinal, d'autres zones agencées selon l'ordre suivant : une seconde zone de maintenance (6'), une seconde zone de traitement (5'), une seconde zone de transfert (4') et une seconde zone de transport (3'); les composants du segment de procédé (12) alimentant aussi bien les zones déjà en place que les zones additionnelles.

5. Dispositif selon la revendication 3, la zone de maintenance (6) et le segment de procédé (12) étant suivis d'autres zones agencées selon l'ordre suivant : une zone de traitement (5') supplémentaire, une zone de transfert (4') supplémentaire et une zone de transport (3') supplémentaire.

6. Dispositif selon l'une des revendications précédente, les composants agencés dans les zones citées ne débordant pas la zone délimitée par les dimensions extérieures du bâti de support (1).

7. Dispositif selon l'une des revendications précédente, la zone de maintenance (6) bien accessible de l'extérieur disposée à l'arrière de l'unité de traitement ne contenant pas de composants.

8. Dispositif selon l'une des revendications précédente, le dispositif de transfert dans la zone de transfert (4) et/ou dans la zone de transfert supplémentaire (4') présentant respectivement au moins un chariot de préhension (4a, 4b, 4c), et l'unité de traitement dans la zone de traitement (5) et/ou dans la zone de traitement supplémentaire (5') présentant respectivement une chambre à vide avec un nombre de places prédéfinissable, de préférence avec quatre places.

9. Dispositif selon la revendication 8, un premier chariot de préhension (4b) étant agencé entre une première zone de transport (3) et une première zone de traitement (5), et un second chariot de préhension (4c) étant agencé entre une zone de transport (3') supplémentaire et une zone de traitement (5') supplémentaire ; la première zone de transport (3) étant aménagée le long d'une face frontale (2) du bâti de support (1) et la zone de transport supplémentaire (3') étant aménagée entre les zones de traitement (5, 5') et le segment de procédé (12) ; une zone de maintenance supplémentaire (6') pour la zone de traitement supplémentaire (5') étant aménagée au niveau de la même face frontale (2) du bâti de support (1) que la première zone de transport (3), et la zone de maintenance (6) pour la première zone de traitement (5) étant, comme la seconde zone de transport (3'), aménagée entre les zones de traitement (5, 5') et le segment de procédé (12).

10. Dispositif selon l'une des revendications précédente, l'un au moins des dispositifs de transport (3, 3') présentant un dispositif d'ajustage pour régler la largeur de son passage.

11. Dispositif selon l'une des revendications précédente, la zone de transport (3) et/ou la zone de transport (3') supplémentaire présentant respectivement deux dispositifs de transport partiel, un dispositif de transport d'entrée (3b) et un dispositif de transport de sortie (3c).

12. Dispositif selon l'une des revendications précédente, la zone de traitement du gaz de procédé (8) présentant une zone non chauffée dans laquelle sont agencés un régulateur de débit massique de gaz vecteur et un capteur de pression absolue.

13. Dispositif selon l'une des revendications précédente, la zone pour pompes à vide (9) présentant deux zones partielles séparées : une zone partielle de préévacuation (10) pour l'obtention d'un vide préliminaire et une zone partielle de vide de procédé (11) pour l'obtention d'un vide de procédé.
